# EUROPEAN PATENT SPECIFICATION

(11) **EP 4 152 207 B1**
(45) Date of publication and mention of the grant of the patent: **12.02.2025**
(21) Application number: 22182803.1
(22) Date of filing: 04.07.2022
(51) Int. Cl.: G06K 19/077, H01L 23/31, H01L 23/66, H01Q 1/22, H01Q 1/36, H01Q 7/00, H01Q 19/22

(54) **CHIP PACKAGING STRUCTURE**
CHIP-VERPACKUNGSSTRUKTUR
STRUCTURE D'ENCAPSULATION DE PUCE

(30) Priority: 16.09.2021 US 202163245090 P; 11.03.2022 TW 111108946
(43) Date of publication of application: 22.03.2023
(73) Proprietor: SES RFID Solutions GmbH, 40489 Düsseldorf (DE)
(72) Inventor: LIAW, Shao-Lun, 407 Taichung City (TW); LI, Yu-Cheng, 427 Taichung City (TW)
(74) Representative: Viering, Jentschura & Partner mbB Patent- und Rechtsanwälte

(56) References cited:
- WO-A1-01/36220
- US-A1- 2013 140 368
- US-A1- 2018 264 898
- US-A1- 2021 082 841
- US-A1- 2021 098 858

## Description

### Background of the Disclosure

### 1. Field of the Disclosure

The present invention relates generally to packaging chips, and more particularly to a chip packaging structure.

### 2. Description of the Prior Art

In the automotive industry, radio frequency identification (RFID) technology is becoming increasingly popular. For example, by implanting RF tags, instead of wired sensors, in tires or other vehicle parts, the usage of tires can be tracked through RF tag readers installed at specific locations such as toll booths or checkpoints. However, no matter in a static state or in use, the harsh environment inside a tire may cause damage to the implanted RFID tag. Therefore, how to improve the durability of RFID tags is an essential issue for the industry.

US 2013/0140368 A1 which is reflected in the preamble of claim 1 discloses a radio frequency identification tag including a housing shaped as a stripe defining a longitudinal side and an inlay disposed within the housing. The inlay includes a carrier board supporting a packaged chip and a wiring antenna in connection with the packaged chip. The wiring antenna is formed with an electrical joint directly and electrically connecting the packaged chip and an extension portion directly extending out of the electrical joint. The extension direction of the extension portion is substantially perpendicular to the longitudinal side.

Other related prior art is disclosed in US 2021/0098858 A1, US 2021/0082841 A1, US 2018/0264898 A1 and WO 01/36220 A1.

### Summary of the Disclosure

According to the present invention, a chip packaging structure according to claim 1 is provided. Preferred embodiments are further defined in the dependent claims.

In view of the situation mentioned above, the present invention provides a chip packaging structure, which could enhance the durability of a packaged chip, and therefore would be more suitable for the automotive industry.

The present invention provides a chip packaging structure, which includes a miniature antenna, a radio frequency identification chip electrically connected to the miniature antenna, and a packaging member adapted to encapsulate the miniature antenna and the radio frequency identification chip. The packaging member has a top surface, a bottom surface, and a plurality of lateral surfaces; the top surface is opposite to the bottom surface, and the lateral surfaces all connect the top surface and the bottom surface; the top surface, the bottom surface, and the lateral surfaces substantially form a hexahedron.

In an embodiment, the top surface and the bottom surface are substantially parallel to each other, and at least one of the lateral surfaces connects the top surface and the bottom surface in a slanted manner.

In an embodiment, the top surface and the bottom surface are substantially parallel to each other, and all of the lateral surfaces connect the top surface and the bottom surface in a substantially orthogonal manner.

In the present invention, the chip packaging structure further includes a linear antenna, which includes a first extension portion, a second extension portion, and a winding portion, wherein the first extension portion is linked to the winding portion, the second extension portion is linked to the winding portion, and the winding portion winds around the lateral surfaces of the packaging member.

In the present invention, a junction of each two adjacent ones of the lateral surfaces is defined as a corner portion. The first extension portion leaves the packaging member from one of the corner portions, and the second extension portion also leaves the packaging member from the same one of the corner portions.

In the present invention, the chip packaging structure further includes an adhesive, which is adapted to adhere the winding portion of the linear antenna to the packaging member. The adhesive at least covers: the corner portion from where the first extension portion and the second extension portion leave the packaging member; at least a part of one of the lateral surfaces adjacent to said corner portion; and at least a part of the other one of lateral surfaces that is adjacent to said corner portion.

In an embodiment, a junction of each two adjacent ones of the lateral surfaces is defined as a corner portion. The first extension portion leaves the packaging member from one of the corner portions, and the second extension portion leaves the packaging member from another one of the corner portions. Said corner portion and said another corner portion are opposite to each other.

In an embodiment, the chip packaging structure further includes an adhesive, which is adapted to adhere the winding portion of the linear antenna to the packaging member; wherein a part of the winding portion of the linear antenna linked to the first extension portion abuts against one of the lateral surfaces, and another part of the winding portion linked to the second extension portion abuts against another one of the lateral surfaces. The adhesive at least covers: at least a part of the one of the lateral surfaces which is abutted against by the part of the winding portion linked to the first extension portion; at least a part of the another one of the lateral surfaces which is abutted against by the another part of the winding portion linked to the second extension portion; and the corner portion defined by said lateral surface and said another lateral surface junction.

In an embodiment, a junction of each two adjacent ones of the lateral surfaces is defined as a corner portion. The first extension portion leaves the packaging member from one of the corner portions, and the second extension portion leaves the packaging member from another one of the corner portions. Said corner portion and said another corner portion are adjacent to each other.

In an embodiment, the chip packaging structure further includes an adhesive, which is adapted to adhere the winding portion of the linear antenna to the packaging member; wherein a part of the winding portion of the linear antenna linked to the first extension portion abuts against one of the lateral surfaces, and another part of the winding portion linked to the second extension portion also abuts against the same one of the lateral surfaces. The adhesive at least covers: said lateral surface which is abutted against by the part of the winding portion linked to the first extension portion and the another part of the winding portion linked to the second extension portion; the corner portion from where the first extension portion leaves the packaging member; the another corner portion from where the second extension portion leaves the packaging member; and at least a part of each of two of the lateral surfaces which are adjacent to said lateral surface.

In an embodiment, the chip packaging structure further includes an adhesive, which is adapted to adhere the winding portion of the linear antenna to the packaging member, wherein the adhesive covers at least one of the lateral surfaces.

In an embodiment, the adhesive also covers at least one of the top surface and the bottom surface.

In an example useful for understanding but not forming part of the invention, the chip packaging structure further includes an adhesive, which is adapted to adhere the winding portion of the linear antenna to the packaging member, wherein the adhesive covers at least one of the top surface and the bottom surface.

In an embodiment, a junction of each two adjacent ones of the lateral surfaces is defined as a corner portion. The first extension portion leaves the packaging member from one of the corner portions, and the second extension portion leaves the packaging member from another one of the corner portions. An end of the first extension portion away from the winding portion and an end of the second extension portion away from the winding portion are integrally connected.

In an embodiment, the chip packaging structure further includes an adhesive, which is adapted to adhere the winding portion of the linear antenna to the packaging member, wherein said corner portion from where the first extension portion leaves the packaging member and said another corner portion from where the second extension portion leaves the packaging member are adjacent to each other. The adhesive covers: said corner portion and said another corner portion; the lateral surface which connects said corner portion and said another corner portion; and at least a part of each of two of the lateral surfaces which are adjacent to said lateral surface.

In an example useful for understanding but not forming part of the invention, the chip packaging structure further includes a linear antenna, which includes a first extension portion, a second extension portion, and a winding portion, wherein the first extension portion is linked to the winding portion, the second extension portion is linked to the winding portion, and the winding portion winds around the top surface, the bottom surface, and two of the lateral surfaces of the packaging member.

An example useful for understanding but not forming part of the invention also provides a chip packaging structure, which includes a miniature antenna, a radio frequency identification chip electrically connected to the miniature antenna, and a packaging member adapted to encapsulate the miniature antenna and the radio frequency identification chip. The packaging member includes a first portion and a second portion protruding from the first portion. A size of the second portion is smaller than a size of the first portion.

In an example useful for understanding but not forming part of the invention, the chip packaging structure further includes a linear antenna, which includes a first extension portion, a second extension portion, and a winding portion, wherein the first extension portion is linked to the winding portion, the second extension portion is linked to the winding portion, and the winding portion winds around the first portion of the packaging member.

The present invention further includes a miniature antenna, a radio frequency identification chip electrically connected to the miniature antenna; and a packaging member adapted to encapsulate the miniature antenna and the radio frequency identification chip. The packaging member includes a first portion, a second portion, and a third portion. The first portion and the third portion are respectively connected to two opposite sides of the second portion, and a size of the second portion is smaller than sizes of the first portion and the third portion.

In an embodiment, the chip packaging structure further includes a linear antenna, which includes a first extension portion, a second extension portion, and a winding portion, wherein the first extension portion is linked to the winding portion, the second extension portion is linked to the winding portion, and the winding portion winds around the second portion of the packaging member.

With the design above, the chip packaging structure provided in the present invention has better durability and is more suitable for the interior environment of tires.

### Brief Description of the Drawings

The present invention will be best understood by referring to the following detailed description of one illustrative embodiment in conjunction with the accompanying drawings, in which
FIG. 1 is a perspective view of the chip packaging structure of a first embodiment of the present invention, wherein the miniature antenna and the radio frequency identification chip inside the packaging member are illustrated in dotted lines;

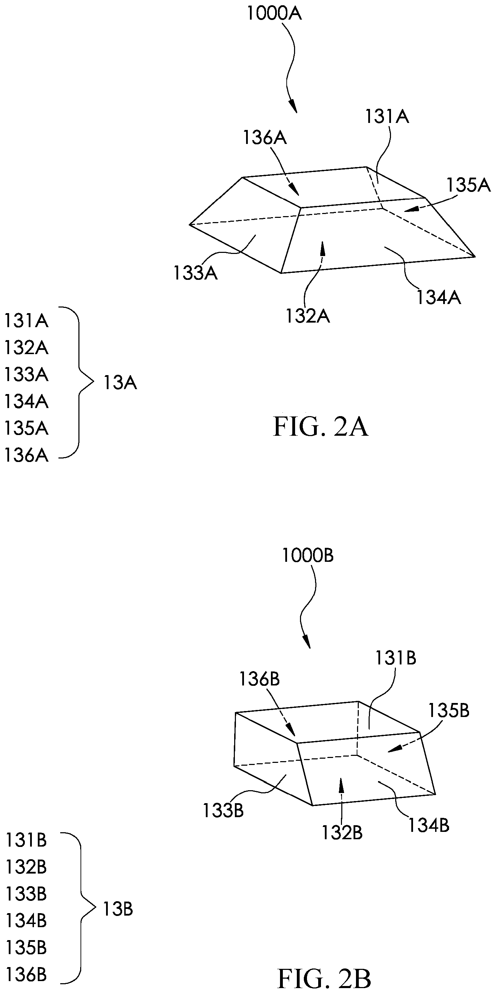

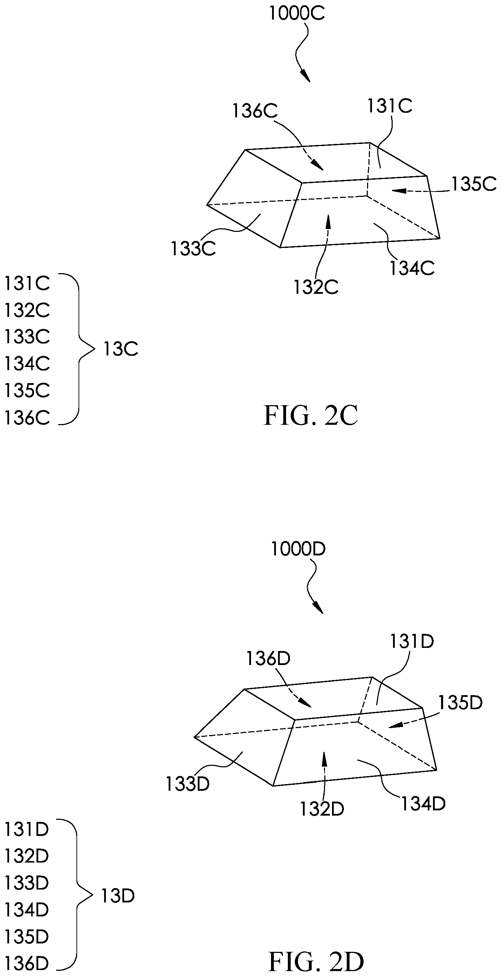

FIGS. 2A-2D are perspective views of several implementations of the first embodiment of the present invention, showing that an area of the top surface of the packaging member is smaller than an area of the bottom surface thereof, and at least a lateral surface connects the top surface and the bottom surface in a slanted manner, wherein FIG. 2A shows an implementation with four slanted lateral surfaces, FIG. 2B shows an implementation with one slanted lateral surface, FIG. 2C shows an implementation with two slanted lateral surfaces, and FIG. 2D shows an implementation with three slanted lateral surfaces;
FIG. 3 is a schematic view of the chip packaging structure of a second embodiment of the present invention, wherein the miniature antenna and the radio frequency identification chip inside the packaging member are illustrated in dotted lines;
FIGS. 4A-4D are top views of several implementations of the chip packaging structure of the second embodiment of the present invention;
FIG. 4E and FIG. 4F are side views of other two implementations of the chip packaging structure of the second embodiment of the present invention;
FIG. 4G is a top view of yet another implementation of the chip packaging structure of the second embodiment of the present invention;
FIG. 4H is a schematic view of

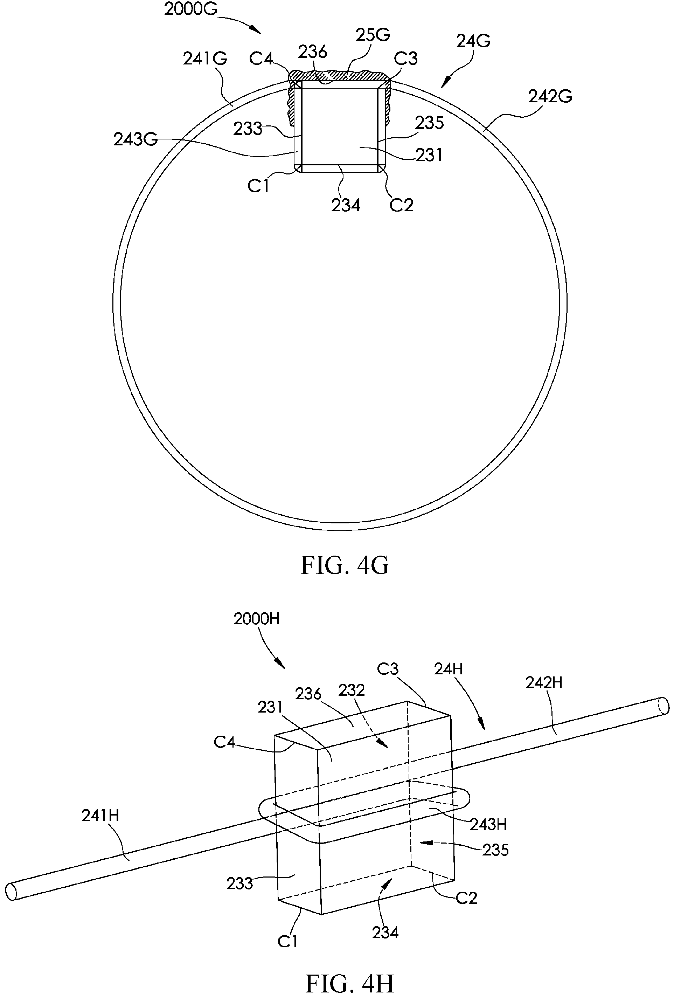

FIG. 4H is a schematic view of another implementation of the chip packaging structure of the second embodiment of the present invention;

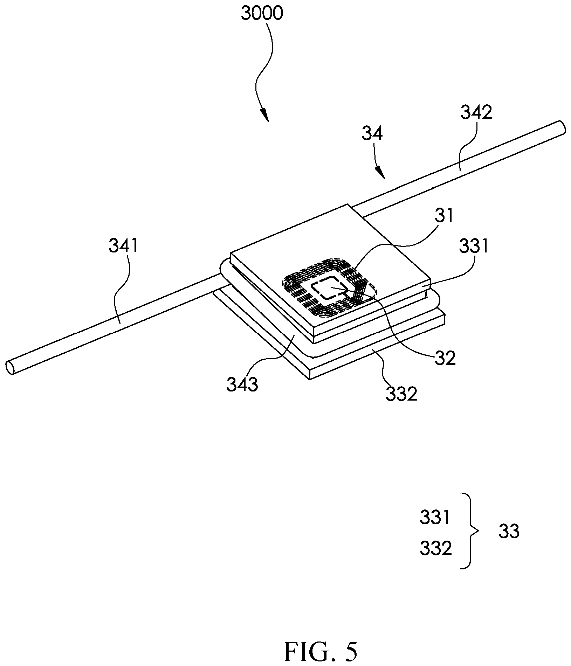

FIG. 5 is a perspective view of the chip packaging structure of a third embodiment of the present invention;

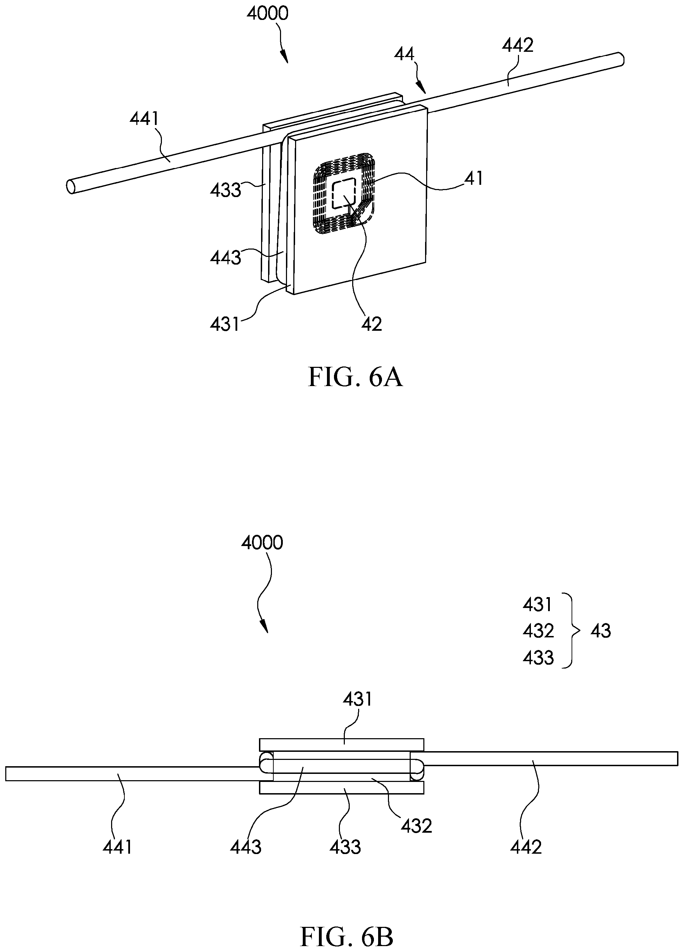

FIG. 6A is a perspective view of the chip packaging structure of a fourth embodiment of the present invention;
FIG. 6B is a side view of the chip packaging structure of the fourth embodiment mentioned above; and

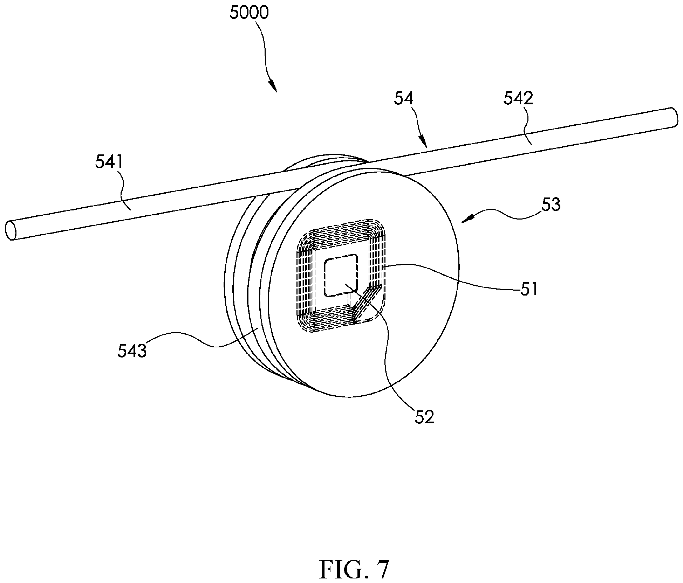

FIG. 7 is a perspective view of the chip packaging structure of a fifth embodiment of the present invention.

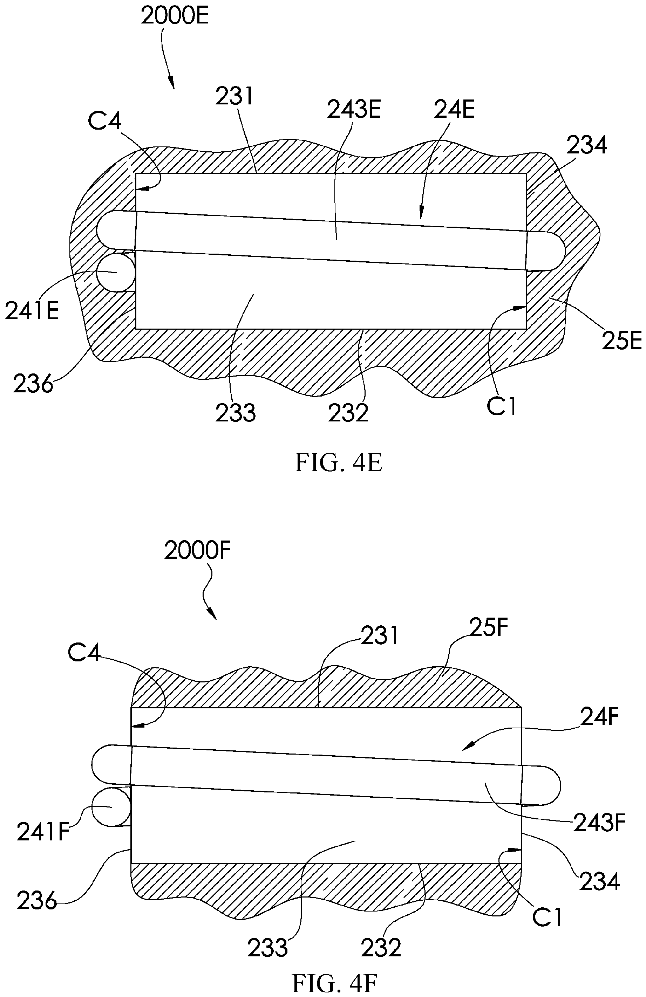

Despite being described as "embodiments", the examples shown in FIG. 4F, FIG. 4H and FIG. 7 do not form part of the present invention but are useful for understanding the present invention.

### Detailed Description

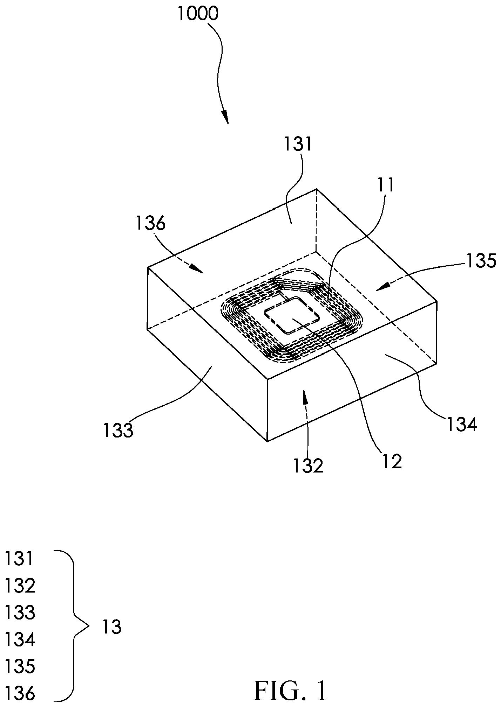

FIG. 1 is a perspective view of a chip packaging structure 1000 of a first embodiment of the present invention, including a miniature antenna 11, a radio frequency identification chip 12, and a packaging member 13, wherein the radio frequency identification chip 12 is electrically connected to the miniature antenna 11, and the packaging member 13 is adapted to encapsulate the miniature antenna 11 and the identification chip 12. The packaging member 13 has a top surface 131, a bottom surface 132, a first lateral surface 133, a second lateral surface 134, a third lateral surface 135, and a fourth lateral surface 136, wherein the top surface 131 is opposite to the bottom surface 132, and the first to the fourth lateral surfaces 133, 134, 135, 136 all connect the top surface 131 and the bottom surface 132. The top surface 131, the bottom surface 132, and the first to the fourth lateral surfaces 133, 134, 135, 136 substantially form a hexahedron. In the current embodiment, the top surface 131 and the bottom surface 132 are substantially parallel, and have substantially equal sizes. In other words, the first to the fourth lateral surfaces 133, 134, 135, 136 are all substantially orthogonal to the top surface 131 and the bottom surface 132. However, the exact appearance of the hexahedron packaging member 13 is not a limitation of the present invention.

Several implementations of the chip packaging structure of the first embodiment of the present invention are shown in FIG. 2A to FIG. 2D, disclosing several possible appearances of the packaging member (the miniature antenna and the identification chip inside the packaging member are not shown). Wherein, FIG. 2A shows another implementation of the chip packaging structure of the first embodiment, denoted as 1000A. In the chip packaging structure 1000A, a packaging member 13A is also a hexahedron, which has a top surface 131A, a bottom surface 132A, a first lateral surface 133A, a second lateral surface 134A, a third lateral surface 135A, and a fourth lateral surface 136A. Furthermore, the top surface 131A and the bottom surface 132A thereof are substantially parallel as well. The difference between the chip packaging structure 1000A and the implementation mentioned above is that a size of the top surface 131A is smaller than a size of the bottom surface 132A, and the first to the fourth lateral surfaces 133A, 134A, 135A, 136A all connect the top surface 131A and the bottom surface 132A in a slanted manner. Of course, it is not a limitation of the present invention that all of the lateral surfaces of a packaging member have to connect a top surface and a bottom surface in a slanted manner. For instance, another implementation of a chip packaging structure of the first embodiment illustrated in FIG. 28, which is denoted as 1000B, has a packaging member 13B having a top surface 131B, a bottom surface 132B, a first lateral surface 133B, a second lateral surface 134B, a third lateral surface 135B, and a fourth lateral surface 136B. The top surface 131B and the bottom surface 132B are substantially parallel, and the second lateral surface 134B, the third lateral surface 135B, and the fourth lateral surface 136B are all substantially orthogonal to the top surface 131B and the bottom surface 132B; mere the second lateral surface 134B connects the top surface 131B and the bottom surface 132B in a slanted manner. Similarly, a packaging member 13C of a chip packaging structure 1000C shown in FIG. 2C has a top surface 131C, a bottom surface 132C, a first lateral surface 133C, a second lateral surface 134C, a third lateral surface 135C, and a fourth lateral surface 136C, wherein the top surface 131C and the bottom surface 132C are substantially parallel, and the third lateral surface 135C and the fourth lateral surface 136C are both substantially orthogonal to the top surface 131C and the bottom surface 132C, while the first lateral surface 133C and the second lateral surface 134C both connect the top surface 131C and the bottom surface 132C in a slanted manner. As for a packaging member 13D of a chip packaging structure 1000D shown in FIG. 2D, it also has a top surface 131D, a bottom surface 132D, a first lateral surface 133D, a second lateral surface 134D, a third lateral surface 135D, and a fourth lateral surface 136D, wherein the top surface 131D and the bottom surface 132D are substantially parallel, and only the third lateral surface 135D is substantially orthogonal to the top surface 131D and the bottom surface 132D, while the rest lateral surfaces (i.e., the first lateral surface 133D, the second lateral surface 134D, and the fourth lateral surface 136D) all connect the top surface 131D and the bottom surface 132D in a slanted manner.

In brief, with the implementations of the first embodiment of the present invention mentioned above including the chip packaging structures 1000, 1000A, 1000B, 1000C, and 1000D, it could be understood that, in the current embodiment, as long as the packaging member 13, 13A, 13B, 13C, 13D is substantially hexahedron, how the lateral surfaces are arranged and the relative sizes of the top surface and the bottom surface are not limitations of the present invention.

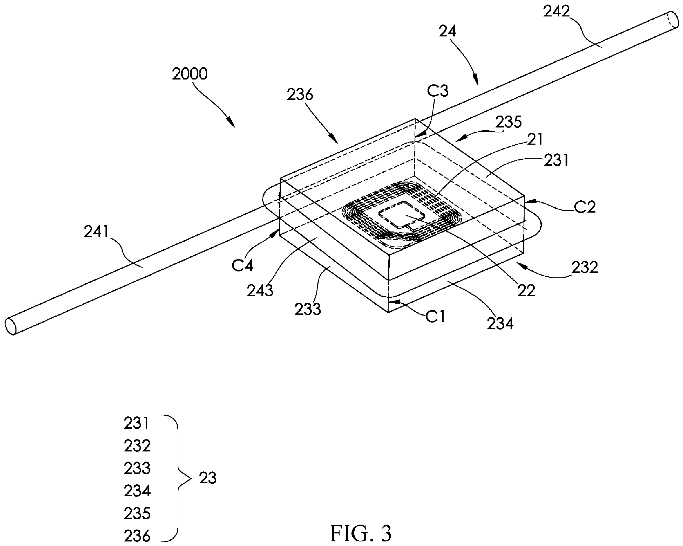

A chip packaging structure 2000 of a second embodiment of the present invention is shown in FIG. 3, wherein the chip packaging structure 2000 not only includes a miniature antenna 21, a radio frequency identification chip 22, and a packaging member 23, but also includes a linear antenna 24. The radio frequency identification chip 22 is also electrically connected to miniature antenna 21, and the packaging member 23 is adapted to encapsulate the miniature antenna 21 and the identification chip 22 as well. The same as the previous embodiment, the packaging member 23 has a top surface 231, a bottom surface 232, a first lateral surface 233, a second lateral surface 234, a third lateral surface 235, and a fourth lateral surface 236, wherein the top surface 231 is opposite to the bottom surface 232, and the first to the fourth lateral surfaces 233, 234, 235, 236 connect the top surface 231 and the bottom surface 232 in a manner that the packaging member 23 substantially renders a hexahedron appearance. It needs to be clarified that, though the current embodiment is based on the specific implementation of packaging member described in the previous embodiment that all lateral surfaces are orthogonal to the top surface and the bottom surface (i.e., the one illustrated in FIG. 1), this is not the limitation of the present invention; other implementations of packaging members described in the previous embodiment could be used as a basis of the current embodiment as well. What is shown herein is merely an example.

The linear antenna 24 includes a first extension portion 241, a second extension portion 242, and a winding portion 243, wherein the first extension portion 241 is linked to the winding portion 243, the second extension portion 242 is linked to the winding portion 243, and the winding portion 243 winds around the first lateral surface 233, the second lateral surface 234, the third lateral surface 235, and the fourth lateral surface 236 of the packaging member 23. In other words, the linear antenna 24 winds around the packaging member 23 through the winding portion 243 thereof. To better understand the winding relationship between the linear antenna 24 and the packaging member 23, herein we define the junctions of each two neighboring lateral surfaces 233, 234, 235, 236 of the packaging member 23 as a corner portion. More specifically, the junction of the first lateral surface 233 and the second lateral surface 234 of the packaging member 23 is defined as a first corner portion C1, the junction of the second lateral surface 234 and the third lateral surface 235 is defined as a second corner portion C2, the junction of the third lateral surface 235 and the fourth lateral surface 236 is defined as a third corner portion C3, and the junction of the fourth lateral surface 236 and the first lateral surface 233 is defined as a fourth corner portion C4. The first extension portion 241 of the linear antenna 24 leaves the packaging member 23 from one of the corner portions C1, C2, C3, C4, and the second extension portion 242 also leaves the packaging member 23 from one of the corner portions C1, C2, C3, C4. In the current embodiment, the first extension portion 241 of the linear antenna 24 leaves the packaging member 23 from a different one of the corner portions C1, C2, C3, C4 from where the second extension portion 242 leaves the packaging member 23, and these two corner portions C1, C2, C3, C4 are adjacent. More specifically, in the current embodiment, the first extension portion 241 leaves the packaging member 23 from the fourth corner portion C4, while the second extension portion 242 leaves the packaging member 23 from the third corner portion C3, wherein the third corner portion C3 and the fourth corner portion C4 are two adjacent corner portions. It should be realized that the extension portions 241, 242 of the linear antenna 24 are not limited to leaving the packaging member 23 from the above-specified locations. In the following implementations of the second embodiment, we will see further illustrations.

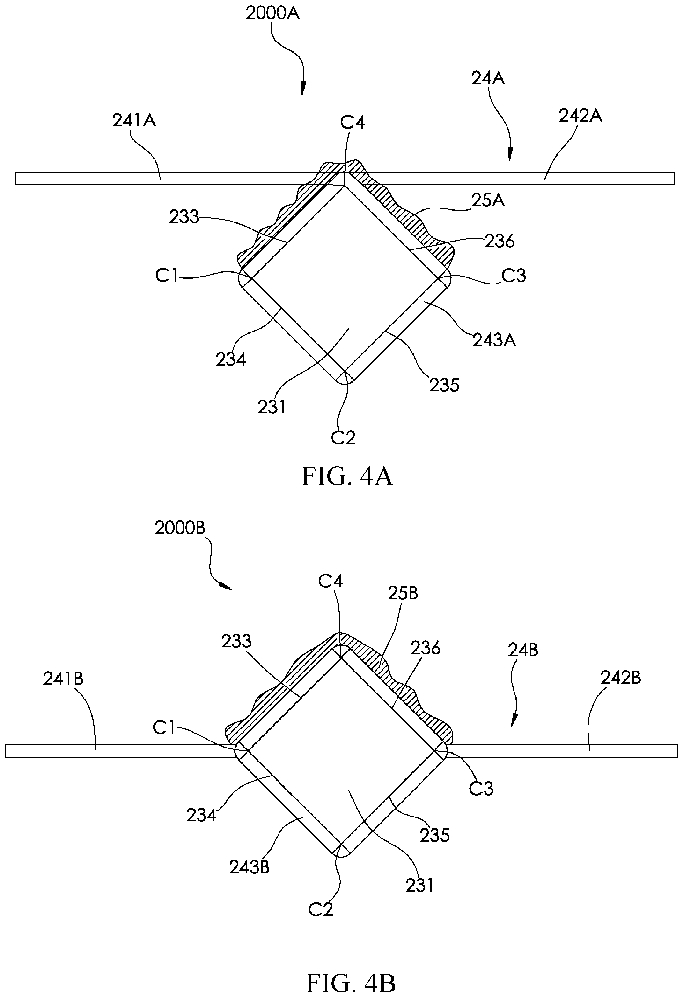

Several implementations of the second embodiment of the present invention are respectively shown in FIG. 4A to FIG. 4H. It should be noted that, in each of the implementations of the second embodiment of the present invention shown in FIG. 4A to FIG. 4H, the structure of the packaging member is identical to that of the packaging member 23 shown in FIG. 3, and therefore all reference markings related to the packaging member seen in these figures are directly from FIG. 3; no new reference markings are further added. In addition, for the sake of simplicity, the miniature antenna and the identification chip inside the packaging member 23 are all omitted in FIG. 4A to FIG. 4H. Please bear in mind, this does not mean that these two components (i.e., the miniature antenna and the identification chip) are not included in these implementations.

A chip packaging structure 2000A of another implementation of the second embodiment is shown in FIG. 4A, which has basically the same design as that illustrated in FIG. 3. A linear antenna 24A included therein also has a first extension portion 241A, a second extension portion 242A, and a winding portion 243A. In addition, the chip packaging structure 2000A further includes an adhesive 25A, which is adapted to adhere the winding portion 243A of the linear antenna 24A to the packaging member 23. This implementation is different from that shown in FIG. 3 by the fact that the first extension portion 241A and the second extension portion 242A of the linear antenna 24A leave the packaging member 23 from the same one of the corner portions C1, C2, C3, C4. More specifically, in this implementation of the second embodiment, the first extension portion 241A and the second extension portion 242A both leave the packaging member 23 from the fourth corner portion C4, only with opposite extending directions. In addition, the adhesive covers the specific one of the corner portions C1, C2, C3, C4 where the first extension portion 241A and the second extension portion 242A leave the packaging member 23, and at least a part of each of the two lateral surfaces adjacent to said corner portion C1, C2, C3, C4. In other words, in the current implementation, the adhesive 25A covers the fourth corner portion C4, where the first extension portion 241A and the second extension portion 242A leave the packaging member 23, and almost the entire surfaces of the first lateral surface 233 and the fourth lateral surface 236, which are adjacent to the fourth corner portion C4.

Another implementation of a chip packaging structure 2000B of the second embodiment of the present invention is shown in FIG. 4B, which also includes a linear antenna 24B and an adhesive 25B, wherein the linear antenna 24B has a first extension portion 241B, a second extension portion 242B, and a winding portion 243B. Different from the previous implementation, the first extension portion 241B and the second extension portion 242B of the current implementation leave the packaging member 23 from two different ones of the corner portions C1, C2, C3, C4, and these two corner portions C1, C2, C3, C4 are opposite to each other. More specifically, in the current implementation, the first extension portion 241B leaves the packaging member 23 from the first corner portion C1, while the second extension portion 242B leaves the packaging member 23 from the third corner portion C3, wherein the first corner portion C1 is opposite to the third corner portion C3. In addition, the adhesive 25B is also adapted to adhere the winding portion 243B of the linear antenna 24B to the packaging member 23. A part of the winding portion 243B of the linear antenna 24B linked to the first extension portion 241B abuts against one of the lateral surfaces 233, 234, 235, 236 of the packaging member 23, and another part of the winding portion 243B linked to the second extension portion 242B abuts against another one of the lateral surfaces 233, 234, 235, 236 of the packaging member 23. The adhesive 25B at least covers at least a part of the one lateral surface 233, 234, 235, 236 which is abutted against by the part of the winding portion 243B linked to the first extension portion 241B, at least a part of the another lateral surface 233, 234, 235, 236 which is abutted against by the another part of the winding portion 243B linked to the second extension portion 242B, and the corner portion C1, C2, C3, C4 which is defined by the junction of the above-mentioned one lateral surface 233, 234, 235, 236 and the another one lateral surface 233, 234, 235, 236. In this implementation of the second embodiment, the part of the winding portion 243B of the linear antenna 24B linked to the first extension portion 241B abuts against the first lateral surface 233 of the packaging member 23, and the another part of the winding portion 243B linked to the second extension portion 242B abuts against the fourth lateral surface 236 of the packaging member 23. The adhesive 25B covers the entire surfaces of the first lateral surface 233 and the fourth lateral surface 236, and the fourth corner portion C4 between the first lateral surface 233 and the fourth lateral surface 236.

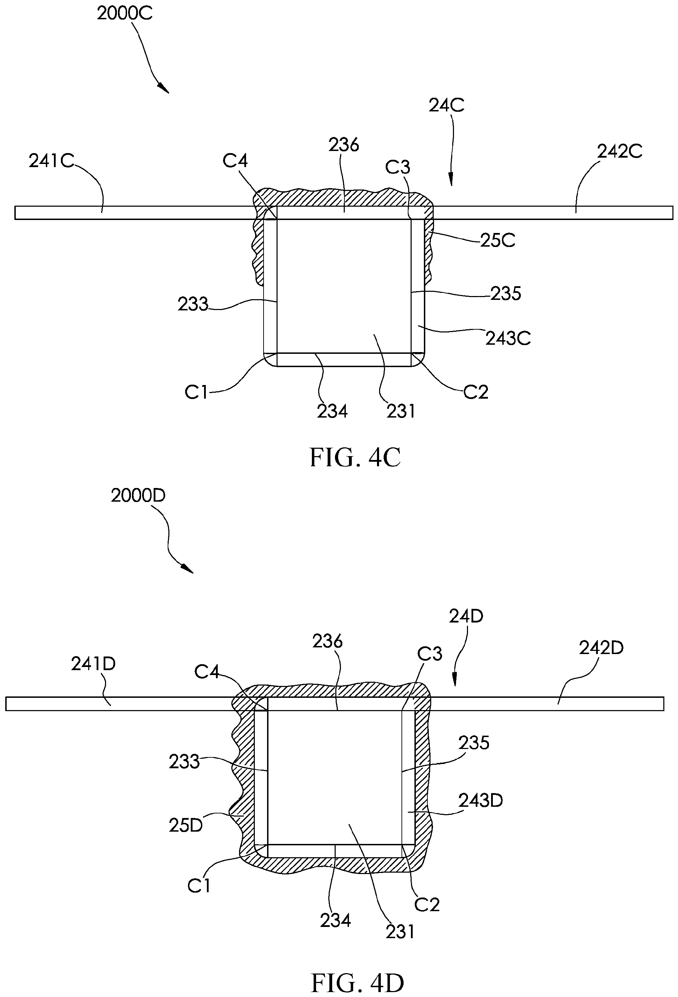

Another implementation of a chip packaging structure 2000C of the second embodiment of the present invention is shown in FIG. 4C, which also has a linear antenna 24C and an adhesive 25C, wherein the linear antenna 24C has a first extension portion 241C, a second extension portion 242C, and a winding portion 243C. Different from the previously mentioned implementations, the one corner portion C1, C2, C3, C4 where the first extension portion 241C leaves packaging member 23 is adjacent to the another one corner portion C1, C2, C3, C4 where the second extension portion 242C leaves the packaging member 23. In the current implementation, the first extension portion 241C leaves the packaging member 23 from the fourth corner portion C4, and the second extension portion 242C leaves the packaging member 23 from the third corner portion C3, wherein the third corner portion C3 and the fourth corner portion C4 are two adjacent corner portions. In addition, the adhesive 25C is adapted to adhere the winding portion 243C of the linear antenna 24C to the packaging member 23. A part of the winding portion 243C of the linear antenna 24C linked to the first extension portion 241C abuts against one of the lateral surfaces 233, 234, 235, 236 of the packaging member 23, and another part of the winding portion 243C linked to the second extension portion 242C also abuts against the same one of the lateral surfaces 233, 234, 235, 236 of the packaging member 23. The adhesive 25C at least covers the entire surface of the specific one of the lateral surfaces 233, 234, 235, 236 which is abutted against by the part of winding portion 243C linked to the first extension portion 241C and also by the another part of the winding portion 243C linked to the second extension portion 242C, the one corner portion C1, C2, C3, C4 where the first extension portion 241C leaves the packaging member 23, the another one corner portion C1, C2, C3, C4 where the second extension portion 242C leaves the packaging member 23, and at least a part of each of two lateral surfaces 233, 234, 235, 236 which are adjacent to the specific one lateral surface 233, 234, 235, 236 mentioned above. In the current implementation of the second embodiment, the part of the winding portion 243C of the linear antenna 24C linked to the first extension portion 241C and the another part of the winding portion 243C linked to the second extension portion 242C both abuts against the fourth lateral surface 236 of the packaging member 23, and the adhesive 25B covers the fourth lateral surface 236, the fourth corner portion C4 where the first extension portion 241C leaves the packaging member 23, the third corner portion C3 where the second extension portion 242C leaves the packaging member 23, and a part of the surface of each of the first lateral surface 233 and the third lateral surface 235 which are adjacent to the fourth lateral surface 236.

Another implementation of a chip packaging structure 20000 of the second embodiment of the present invention is shown in FIG. 4D, which also has a linear antenna 24D and an adhesive 25D, wherein the linear antenna 24D has a first extension portion 241D, a second extension portion 242D, and a winding portion 243D. The current implementation is basically identical to the implementation shown in FIG. 4C. In other words, the first extension portion 241D also leaves the packaging member 23 from the fourth corner portion C4, and the second extension portion 242D leaves the packaging member 23 from the third corner portion C3 as well. In addition, the adhesive 25D is also adapted to adhere the winding portion 243D of the linear antenna 24D to the packaging member 23. Different from the previously mentioned implementations, in the current implementation of the second embodiment, the adhesive 25D completely covers all of the lateral surfaces 233, 234, 235, 236 of the packaging member 23. However, this is not a limitation of the present invention. In practice, the adhesive 25D could be adjusted by demand to only cover at least one of the lateral surfaces 233, 234, 235, 236 of the packaging member 23.

Another implementation of a chip packaging structure 2000E of the second embodiment of the present invention is shown in FIG. 4E. Similarly, the chip packaging structure 2000E has a linear antenna 24E and an adhesive 25E, wherein the linear antenna 24E has a first extension portion 241E, a second extension portion 242E, and a winding portion 243E. The current implementation is basically identical to the implementation shown in FIG. 4D. In other words, the first extension portion 241E also leaves the packaging member 23 from the fourth corner portion C4, and the second extension portion (not shown in FIG. 4E due to the angle of view) leaves the packaging member 23 from the third corner portion C3 as well. Furthermore, the adhesive 25Ea is also adapted to adhere the winding portion 243E of the linear antenna 24E to the packaging member 23. Different from the implementation shown in FIG. 4D, in the current implementation of the second embodiment, the adhesive 25E completely covers the top surface 231, the fourth lateral surface 236, the bottom surface 232, and the second lateral surface 234 of the packaging member 23. However, this is not a limitation of the present invention. In practice, the adhesive 25E could be adjusted by demand to not only cover the at least one of the lateral surfaces 233, 234, 235, 236 of the packaging member 23, but also cover at least one of the top surface 231 and the bottom surface 232.

Another implementation of a chip packaging structure 2000F of the second embodiment of the present invention is shown in FIG. 4F, which has a linear antenna 24F and an adhesive 25F, wherein the linear antenna 24F has a first extension portion 241F, a second extension portion 242F, and a winding portion 243F. The current implementation is basically identical to the implementation shown in FIG. 4E. In other words, the first extension portion 241F also leaves the packaging member 23 from the fourth corner portion C4, and the second extension portion (not shown in FIG. 4F due to the angle of view) leaves the packaging member 23 from the third corner portion C3 as well. Furthermore, the adhesive 25F is also adapted to adhere the winding portion 243F of the linear antenna 24F to the packaging member 23. Different from the implementation shown in FIG. 4E, in the current implementation of the second embodiment, the adhesive 25F only covers the top surface 231 and the bottom surface 232 of the packaging member 23. However, this is not a limitation of the present invention. In practice, the adhesive 25F could be adjusted by demand to only cover at least one of the top surface 231 and the bottom surface 232.

Another implementation of a chip packaging structure 2000G of the second embodiment of the present invention is shown in FIG. 4G, which has a linear antenna 24G and a adhesive 25G, wherein the linear antenna 24G has a first extension portion 241G, a second extension portion 242G, and a winding portion 243G. The first extension portion 241G leaves the packaging member 23 from one of the corner portions C1, C2, C3, C4, and the second extension portion 242G leaves the packaging member 23 from another one of the corner portions C1, C2, C3, C4. Furthermore, ends of the first extension portion 241G and the second extension portion 242G which are away from the winding portion 243G are integrally connected to form a ring. More specifically, in the current implementation of the second embodiment, the first extension portion 241G leaves the packaging member 23 from the fourth corner portion C4, and the second extension portion 242G leaves the packaging member 23 from the third corner portion C3, wherein the third corner portion C3 and the fourth corner portion C4 are two adjacent corner portions. In addition, the adhesive 25G included in the chip packaging structure 2000G is also adapted to adhere the winding portion 243G of the linear antenna 24G to the packaging member 23, wherein the adhesive 25G covers the two corner portions C1, C2, C3, C4 where the first and second extension portions 241G, 242G leave the packaging member 23, the lateral surface 233, 234, 235, 236 which connects these two corner portions C1, C2, C3, C4, and at least a part of each of the two lateral surfaces 233, 234, 235, 236 adjacent to said lateral surface 233, 234, 235, 236. In other words, in the current implementation, the adhesive 25G covers the fourth corner portion C4 where the first extension portion 241G leaves the packaging member 23, the third corner portion C3 where the second extension portion 242G leaves the packaging member 23, the entire surface of the fourth lateral surface 236 connecting the fourth corner portion C4 and the third corner portion C3, and a part of the surfaces of the first lateral surface 231 and the third lateral surface 235 which are adjacent to the fourth lateral surface 236.

Another implementation of a chip packaging structure 2000F of the second embodiment of the present invention is shown in FIG. 4H, which has a linear antenna 24H, but does not include an adhesive. The linear antenna 24H has a first extension portion 241H, a second extension portion 242H, and a winding portion 243H. The current implementation is basically identical to the one shown in FIG. 3, except that the winding portion 243H of the linear antenna 24H of the chip packaging structure 2000H winds around the top surface 231, the bottom surface 232, at two of the lateral surfaces 233, 234, 235, 236 of the packaging member 23. More specifically, the winding portion 243H of the linear antenna 24H winds around the top surface 231, the third lateral surface 235, the bottom surface 232, and the first lateral surface 233 of the packaging member 23.

A chip packaging structure 3000 of a third embodiment of the present invention is shown in FIG. 5, which includes a miniature antenna 31, an identification chip 32, and a packaging member 33. The identification chip 32 is electrically connected to the miniature antenna 31, and the packaging member 33 is also adapted to encapsulate the miniature antenna 31 and the identification chip 32. Different from each of the embodiments (and each implementation of each embodiment) mentioned above, the packaging member 33 in the current embodiment does not have a hexahedron appearance. More specifically, the packaging member 33 has a first portion 331 and a second portion 332, wherein the second portion 332 protrudes from the first portion 331, and a size of second portion 332 is smaller than a size of the first portion 331.

Preferably, the chip packaging structure 3000 further includes a linear antenna 34, wherein the linear antenna 34 includes a first extension portion 341, a second extension portion 342, and a winding portion 343. The first extension portion 341 is linked to the winding portion 343, the second extension portion 342 is linked to the winding portion 343, and the winding portion 343 winds around the first portion 331 of the packaging member 33.

A chip packaging structure 4000 of a fourth embodiment of the present invention is shown in FIG. 6A and FIG. 6B, which includes a miniature antenna 41, an identification chip 42, and a packaging member 43. Similarly, the identification chip 42 is electrically connected to the miniature antenna 41, and the packaging member 43 is adapted to encapsulate the miniature antenna 41 and the identification chip 42. In addition, the packaging member 43 includes a first portion 431, a second portion 432, and a third portion 433, wherein the first portion 431 and the third portion 433 are connected to opposite sides of the second portion 432, respectively. A size of the second portion 432 is smaller than sizes of the first portion 431 and the third portion 433.

Preferably, the chip packaging structure 4000 further includes a linear antenna 44, wherein the linear antenna 44 includes a first extension portion 441, a second extension portion 442, and a winding portion 443. The first extension portion 441 is linked to the winding portion 443, the second extension portion 442 is linked to the winding portion 443, and the winding portion 443 winds around the second portion 432 of the packaging member 43.

A chip packaging structure 5000 of a fifth embodiment of the present invention is shown in FIG. 7, which includes a miniature antenna 51, an identification chip 52, a packaging member 53, and a linear antenna 54. Similar to the above embodiments, the identification chip 52 is electrically connected to the miniature antenna 51, and the packaging member 53 is adapted to encapsulate the miniature antenna 51 and the identification chip 52. Furthermore, the linear antenna 54 includes a first extension portion 541, a second extension portion 542, and a winding portion 543. The first extension portion 541 is linked to the winding portion 543, the second extension portion 542 is linked to the winding portion 543, and the winding portion 543 winds around the packaging member 53. Different from the previous embodiment, an appearance of the packaging member 53 in the current embodiment is round, and therefore the winding portion 543 of the linear antenna 54 also winds in a correspondingly circular manner. Understandably, in other embodiments, the packaging member could have different shapes such as such as regular polygons, polygons, or irregular shapes, which could be decided by demand, and is not a limitation of the present invention.

It should be noted that the linear antenna mentioned in the embodiments and various variations of the implementations mentioned above has a conductive metal, which serves to enhance the capability of the miniature antenna inside the packaging member. The direction of winding on the packaging member is not a limitation of the present invention, and it can be in clockwise or anti-clockwise direction. In addition, the number of turns of winding is not limited by previous examples, either.

With the design mentioned in each of the above embodiments, the chip packaging structure provided in the present invention could withstand large forces and is not easily damaged, and therefore could better protect the identification chip inside the packaging member.

It should be realized that the above description is only some preferred embodiments of the present invention and should not be deemed as limitations of implementing the present invention which is defined by the appended claims.

## Claims

1. A chip packaging structure (2000, 2000A, 2000B, 2000C, 2000D, 2000E, 2000G, 2000H, 4000), comprising:
a first antenna (21, 41);
a radio frequency identification chip (22, 42) electrically connected to the first antenna (21, 41);
a packaging member (23, 43) encapsulating the first antenna (21, 41) and the radio frequency identification chip (22, 42), wherein the packaging member (23, 43) has a top surface (231), a bottom surface (232), and a plurality of lateral surfaces (233, 234, 235, 236); the top surface (231) is opposite to the bottom surface (232), and the lateral surfaces (233, 234, 235, 236) all connect the top surface (231) and the bottom surface (232); the top surface (231), the bottom surface (232), and the lateral surfaces (233, 234, 235, 236) substantially form a hexahedron; and
a second antenna (24, 24A, 24B, 24C, 24D, 24E, 24F, 24G, 24H, 44), which comprises a first extension portion (241, 241A, 241B, 241C, 241D, 241E, 241F, 241G, 241H, 441), a second extension portion (242, 242A, 242B, 242C, 242D, 242E, 242F, 242G, 242H, 442), and a winding portion (243, 243A, 243B, 243C, 243D, 243E, 243F, 243G, 243H, 443), wherein the first extension portion (241, 241A, 241B, 241C, 241D, 241E, 241F, 241G, 241H, 441) is linked to the winding portion (243, 243A, 243B, 243C, 243D, 243E, 243F, 243G, 243H, 443), the second extension portion (242, 242A, 242B, 242C, 242D, 242E, 242F, 242G, 242H, 442) is linked to the winding portion (243, 243A, 243B, 243C, 243D, 243E, 243F, 243G, 243H, 443), and the winding portion (243, 243A, 243B, 243C, 243D, 243E, 243F, 243G, 243H, 443) winds around the lateral surfaces (233, 234, 235, 236) of the packaging member (23, 43);
wherein a junction of each two adjacent ones of the lateral surfaces (233, 234, 235, 236) is defined as a corner portion (C1, C2, C3, C4); the first extension portion (241, 241A, 241B, 241C, 241D, 241E, 241F, 241G, 241H, 441) and the second extension portion (242, 242A, 242B, 242C, 242D, 242E, 242F, 242G, 242H, 442) respectively leave the packaging member (23, 43) from one of the corner portions (C1, C2, C3, C4);
**characterized in that** the chip packaging structure further comprises an adhesive (25A, 25B, 25C, 25D, 25E, 25F), which is adapted to adhere the winding portion (243, 243A, 243B, 243C, 243D, 243E, 243F, 243G, 243H, 443) of the second antenna (24, 24A, 24B, 24C, 24D, 24E, 24F, 24G, 24H, 44) to the packaging member (23, 43), wherein the adhesive (25A, 25B, 25C, 25D, 25E, 25F) covers at least a part of one of the lateral surfaces (233, 234, 235, 236) and at least one of the corner portions (C1, C2, C3, C4).

2. The chip packaging structure (1000A, 1000B, 1000C, 1000D) of claim 1, wherein the top surface (131A, 131B, 131C, 131D) and the bottom surface (132A, 132B, 132C, 132D) are substantially parallel to each other, and at least one of the lateral surfaces (133A, 133B, 133C, 133D, 134, 134A, 134B, 134C, 134D, 135, 135A, 135B, 135C, 135D, 136, 136A, 136B, 136C, 136D) connects the top surface (131A, 131B, 131C, 131D) and the bottom surface (132A, 132B, 132C, 132D) in a slanted manner.

3. The chip packaging structure (2000, 2000A, 2000B, 2000C, 2000D, 2000E, 2000G, 2000H, 4000) of claim 1, wherein the top surface (231) and the bottom surface (232) are substantially parallel to each other, and all of the lateral surfaces (233, 234, 235, 236) connect the top surface (231) and the bottom surface (232) in a substantially orthogonal manner.

4. The chip packaging structure (2000A) of claim 1, wherein the first extension portion (241A) and the second extension portion (242A) leave the packaging member (23) from a same one of the corner portions (C1, C2, C3, C4), and the adhesive (25A) at least covers:
the corner portion (C1, C2, C3, C4) from where the first extension portion (241A) and the second extension portion (242A) leave the packaging member (23);
at least a part of one of the lateral surfaces (233, 234, 235, 236) adjacent to said corner portion (C1, C2, C3, C4); and
at least a part of the other one of lateral surfaces (233, 234, 235, 236) that is adjacent to said corner portion (C1, C2, C3, C4).

5. The chip packaging structure (2000B) of claim 1, wherein the corner portion (C1, C2, C3, C4) where the first extension portion (241B) leaves the packaging member (23) and the corner portion (C1, C2, C3, C4) where the second extension portion (242B) leaves the packaging member (23) are opposite to each other; a part of the winding portion (243B) of the second antenna (24B) linked to the first extension portion (241B) abuts against one of the lateral surfaces (233, 234, 235, 236), and another part of the winding portion (243B) linked to the second extension portion (242B) abuts against another one of the lateral surfaces (233, 234, 235, 236); the adhesive (25B) at least covers:
at least a part of the one of the lateral surfaces (233, 234, 235, 236) which is abutted against by the part of the winding portion (243B) linked to the first extension portion (241B);
at least a part of the another one of the lateral surfaces (233, 234, 235, 236) which is abutted against by the another part of the winding portion (243B) linked to the second extension portion (242B); and
the corner portion (C1, C2, C3, C4) defined by the junction of said lateral surface (233, 234, 235, 236) and said another lateral surface (233, 234, 235, 236).

6. The chip packaging structure (2000C, 2000D) of claim 1, wherein the corner portion (C1, C2, C3, C4) where the first extension portion (241C, 241D) leaves the packaging member (23) and the corner portion (C1, C2, C3, C4) where the second extension portion (242C, 242D) leaves the packaging member (23) are adjacent to each other; a part of the winding portion (243C, 243D) of the second antenna (24C, 24D) linked to the first extension portion (241C, 241D) abuts against one of the lateral surfaces (233, 234, 235, 236), and another part of the winding portion (243C, 243D) linked to the second extension portion (242C, 242D) also abuts against the same one of the lateral surfaces (233, 234, 235, 236); the adhesive (25C, 25D) at least covers:
said lateral surface which is abutted against by the part of the winding portion (243C, 243D) linked to the first extension portion (241C, 241D) and the another part of the winding portion (243C, 243D) linked to the second extension portion (242C, 242D);
the corner portion (C1, C2, C3, C4) from where the first extension portion (241C, 241D) leaves the packaging member (23);
the another corner portion (C1, C2, C3, C4) from where the second extension portion (242C, 242D) leaves the packaging member (23); and
at least a part of each of two of the lateral surfaces (233, 234, 235, 236) which are adjacent to said lateral surface (233, 234, 235, 236).

7. The chip packaging structure (2000A, 2000B, 2000C, 2000D, 2000E, 2000G,) of claim 1, wherein the adhesive (25A, 25B, 25C, 25D, 25E, 25F, 25G) covers one of the lateral surfaces (233, 234, 235, 236).

8. The chip packaging structure (2000G) of claim 1, wherein the first extension portion (241G) leaves the packaging member (23) from one of the corner portions (C1, C2, C3, C4), and the second extension portion (242G) leaves the packaging member (23) from another one of the corner portions (C1, C2, C3, C4); an end of the first extension portion (241G) away from the winding portion (243G) and an end of the second extension portion (242G) away from the winding portion (243G) are integrally connected; said corner portion (C1, C2, C3, C4) from where the first extension portion (241G) leaves the packaging member (23) and said another corner portion (C1, C2, C3, C4) from where the second extension portion (242G) leaves the packaging member (23) are adjacent to each other; the adhesive (25G) covers:
said corner portion (C1, C2, C3, C4) and said another corner portion (C1, C2, C3, C4);
the lateral surface (233, 234, 235, 236) which connects said corner portion (C1, C2, C3, C4) and said another corner portion (C1, C2, C3, C4); and
at least a part of each of two of the lateral surfaces (233, 234, 235, 236) which are adjacent to said lateral surface (233, 234, 235, 236).

9. The chip packaging structure (4000) of claim 1, wherein the packaging member (43) comprises:
a first portion (431);
a second portion (432); and
a third portion (433);
wherein the first portion (431) and the third portion (433) are respectively connected to two opposite sides of the second portion (432), and a size of the second portion (432) is smaller than sizes of the first portion (431) and the third portion (433).

10. The chip packaging structure (4000) of claim 9, wherein the winding portion (443) winds around the second portion (432) of the packaging member (43).

## Patentansprüche

1. Eine Chip-Verpackungsstruktur (2000, 2000A, 2000B, 2000C, 2000D, 2000E, 2000G, 2000H, 4000), bestehend aus:
eine erste Antenne (21, 41);
ein RFID-Chip (22, 42), der elektrisch mit der ersten Antenne (21, 41) verbunden ist;
ein Verpackungsmitglied (23, 43), das die erste Antenne (21, 41) und den RFID-Chip (22, 42) umschließt, wobei das Verpackungsmitglied (23, 43) eine Oberseite (231), eine Unterseite (232) und eine Vielzahl von Seitenflächen (233, 234, 235, 236) hat;
die Oberseite (231) ist der Unterseite (232) gegenüberliegend, und die Seitenflächen (233, 234, 235, 236) verbinden alle die Oberseite (231) und die Unterseite (232);
die Oberseite (231), die Unterseite (232) und die Seitenflächen (233, 234, 235, 236) bilden im Wesentlichen ein Hexaeder;
und eine zweite Antenne (24, 24A, 24B, 24C, 24D, 24E, 24F, 24G, 24H, 44), die einen ersten Verlängerungsabschnitt (241, 241A, 241B, 241C, 241D, 241E, 241F, 241G, 241H, 441), einen zweiten Verlängerungsabschnitt (242, 242A, 242B, 242C, 242D, 242E, 242F, 242G, 242H, 442) und einen Wicklungsabschnitt (243, 243A, 243B, 243C, 243D, 243E, 243F, 243G, 243H, 443) umfasst, wobei der erste Verlängerungsabschnitt (241, 241A, 241B, 241C, 241D, 241E, 241F, 241G, 241H, 441) mit dem Wicklungsabschnitt (243, 243A, 243B, 243C, 243D, 243E, 243F, 243G, 243H, 443) verbunden ist, der zweite Verlängerungsabschnitt (242, 242A, 242B, 242C, 242D, 242E, 242F, 242G, 242H, 442) mit dem Wicklungsabschnitt (243, 243A, 243B, 243C, 243D, 243E, 243F, 243G, 243H, 443) verbunden ist und der Wicklungsabschnitt (243, 243A, 243B, 243C, 243D, 243E, 243F, 243G, 243H, 443) sich um die Seitenflächen (233, 234, 235, 236) des Verpackungsmitglieds (23, 43) windet;
wobei eine Verbindung jedes zwei benachbarten Seitenflächen (233, 234, 235, 236) als Eckabschnitt (C1, C2, C3, C4) definiert ist; der erste Verlängerungsabschnitt (241, 241A, 241B, 241C, 241D, 241E, 241F, 241G, 241H, 441) und der zweite Verlängerungsabschnitt (242, 242A, 242B, 242C, 242D, 242E, 242F, 242G, 242H, 442) verlassen jeweils das Verpackungsmitglied (23, 43) von einem der Eckabschnitte (C1, C2, C3, C4);
**gekennzeichnet dadurch, dass** die Chip-Verpackungsstruktur zusätzlich einen Klebstoff (25A, 25B, 25C, 25D, 25E, 25F) umfasst, der dazu geeignet ist, den Wicklungsabschnitt (243, 243A, 243B, 243C, 243D, 243E, 243F, 243G, 243H, 443) der zweiten Antenne (24, 24A, 24B, 24C, 24D, 24E, 24F, 24G, 24H, 44) an das Verpackungsmitglied (23, 43) zu kleben, wobei der Klebstoff (25A, 25B, 25C, 25D, 25E, 25F) mindestens einen Teil einer der Seitenflächen (233, 234, 235, 236) und mindestens einen der Eckabschnitte (C1, C2, C3, C4) abdeckt.

2. Die Chip-Verpackungsstruktur (1000A, 1000B, 1000C, 1000D) nach Anspruch 1, wobei die Oberseite (131A, 131B, 131C, 131D) und die Unterseite (132A, 132B, 132C, 132D) im Wesentlichen parallel zueinander sind, und mindestens eine der Seitenflächen (133A, 133B, 133C, 133D, 134, 134A, 134B, 134C, 134D, 135, 135A, 135B, 135C, 135D, 136, 136A, 136B, 136C, 136D) die Oberseite (131A, 131B, 131C, 131D) und die Unterseite (132A, 132B, 132C, 132D) in schräger Weise verbindet.

3. Die Chip-Verpackungsstruktur (2000, 2000A, 2000B, 2000C, 2000D, 2000E, 2000G, 2000H, 4000) nach Anspruch 1, wobei die Oberseite (231) und die Unterseite (232) im Wesentlichen parallel zueinander sind, und alle Seitenflächen (233, 234, 235, 236) die Oberseite (231) und die Unterseite (232) in einer im Wesentlichen orthogonalen Weise verbinden.

4. Die Chip-Verpackungsstruktur (2000A) gemäß Anspruch 1, wobei der erste Verlängerungsabschnitt (241A) und der zweite Verlängerungsabschnitt (242A) das Verpackungsmitglied (23) von demselben Eckabschnitt (C1, C2, C3, C4) verlassen, und der Klebstoff (25A) mindestens abdeckt:
der Eckabschnitt (C1, C2, C3, C4), von dem der erste Verlängerungsabschnitt (241A) und der zweite Verlängerungsabschnitt (242A) das Verpackungsmitglied (23) verlassen;
mindestens ein Teil einer der Seitenflächen (233, 234, 235, 236), die an den genannten Eckabschnitt (C1, C2, C3, C4) angrenzen; und
mindestens ein Teil der anderen der Seitenflächen (233, 234, 235, 236), die an den genannten Eckabschnitt (C1, C2, C3, C4) angrenzen.

5. Die Chip-Verpackungsstruktur (2000B) gemäß Anspruch 1, wobei der Eckabschnitt (C1, C2, C3, C4), an dem der erste Verlängerungsabschnitt (241B) das Verpackungsmitglied (23) verlässt, und der Eckabschnitt (C1, C2, C3, C4), an dem der zweite Verlängerungsabschnitt (242B) das Verpackungsmitglied (23) verlässt, einander gegenüberliegen; ein Teil des Wicklungsabschnitts (243B) der zweiten Antenne (24B), der mit dem ersten Verlängerungsabschnitt (241B) verbunden ist, an einer der Seitenflächen (233, 234, 235, 236) anliegt, und ein anderer Teil des Wicklungsabschnitts (243B), der mit dem zweiten Verlängerungsabschnitt (242B) verbunden ist, an einer anderen der Seitenflächen (233, 234, 235, 236) anliegt; der Klebstoff (25B) bedeckt mindestens:
mindestens ein Teil der einen Seitenfläche (233, 234, 235, 236), an die der Teil des Wicklungsabschnitts (243B) anliegt, der mit dem ersten Verlängerungsabschnitt (241B) verbunden ist;
mindestens ein Teil einer anderen der Seitenflächen (233, 234, 235, 236), an die der andere Teil des Wicklungsabschnitts (243B) anliegt, der mit dem zweiten Verlängerungsabschnitt (242B) verbunden ist; und
der Eckabschnitt (C1, C2, C3, C4), der durch die Verbindung der genannten Seitenfläche (233, 234, 235, 236) und der genannten anderen Mantelfläche (233, 234, 235, 236) definiert ist.

6. Die Chip-Verpackungsstruktur (2000C, 2000D) gemäß Anspruch 1, wobei der Eckabschnitt (C1, C2, C3, C4), an dem der erste Verlängerungsabschnitt (241C, 241D) das Verpackungsmitglied (23) verlässt, und der Eckabschnitt (C1, C2, C3, C4), an dem der zweite Verlängerungsabschnitt (242C, 242D) das Verpackungsmitglied (23) verlässt, nebeneinander liegen; ein Teil des Wicklungsabschnitts (243C, 243D) der zweiten Antenne (24C, 24D), der mit dem ersten Verlängerungsabschnitt (241C, 241D) verbunden ist, an einer der Seitenflächen (233, 234, 235, 236) anliegt, und ein anderer Teil des Wicklungsabschnitts (243C, 243D), der mit dem zweiten Verlängerungsabschnitt (242C, 242D) verbunden ist, ebenfalls an derselben Seitenfläche (233, 234, 235, 236) anliegt; der Klebstoff (25C, 25D) bedeckt mindestens:
der Mantelfläche, an die sowohl der Teil des Wicklungsabschnitts (243C, 243D), der mit dem ersten Verlängerungsabschnitt (241C, 241D) verbunden ist, als auch der andere Teil des Wicklungsabschnitts (243C, 243D), der mit dem zweiten Verlängerungsabschnitt (242C, 242D) verbunden ist, anliegt;
der Eckabschnitt (C1, C2, C3, C4), von dem der erste Verlängerungsabschnitt (241C, 241D) das Verpackungsmitglied (23) verlässt;
der andere Eckabschnitt (C1, C2, C3, C4), von dem der zweite Verlängerungsabschnitt (242C, 242D) das Verpackungsmitglied (23) verlässt; und
mindestens ein Teil von jeweils zwei der Seitenflächen (233, 234, 235, 236), die an die genannte Mantelfläche (233, 234, 235, 236) angrenzen.

7. Die Chip-Verpackungsstruktur (2000A, 2000B, 2000C, 2000D, 2000E, 2000G) gemäß Anspruch 1, wobei der Klebstoff (25A, 25B, 25C, 25D, 25E, 25F, 25G) eine der Seitenflächen (233, 234, 235, 236) bedeckt.

8. Die Chip-Verpackungsstruktur (2000G) gemäß Anspruch 1, wobei der erste Verlängerungsabschnitt (241G) das Verpackungsmitglied (23) von einem der Eckabschnitte (C1, C2, C3, C4) verlässt und der zweite Verlängerungsabschnitt (242G) das Verpackungsmitglied (23) von einem anderen der Eckabschnitte (C1, C2, C3, C4) verlässt; ein Ende des ersten Verlängerungsabschnitts (241G), das vom Wicklungsabschnitt (243G) entfernt ist, und ein Ende des zweiten Verlängerungsabschnitts (242G), das vom Wicklungsabschnitt (243G) entfernt ist, sind integrativ miteinander verbunden; der genannte Eckabschnitt (C1, C2, C3, C4), von dem der erste Verlängerungsabschnitt (241G) das Verpackungsmitglied (23) verlässt, und der genannte andere Eckabschnitt (C1, C2, C3, C4), von dem der zweite Verlängerungsabschnitt (242G) das Verpackungsmitglied (23) verlässt, sind benachbart; der Klebstoff (25G) bedeckt:
der Eckabschnitt (C1, C2, C3, C4) und der anderen Eckabschnitt (C1, C2, C3, C4); die Mantelfläche (233, 234, 235, 236), welche den genannten Eckabschnitt (C1, C2, C3, C4) und den genannten anderen Eckabschnitt (C1, C2, C3, C4) verbindet; und mindestens einen Teil von jeweils zwei der Seitenflächen (233, 234, 235, 236), die an die genannte Mantelfläche (233, 234, 235, 236) angrenzen.

9. Die Chip-Verpackungsstruktur (4000) gemäß Anspruch 1, wobei das Verpackungsmitglied (43) umfasst::
einen ersten Teil (431);
einen zweiten Teil (432); und
einen dritten Teil (433);
wobei der erste Teil (431) und der dritte Teil (433) jeweils mit zwei gegenüberliegenden Seiten des zweiten Teils (432) verbunden sind, und die Größe des zweiten Teils (432) kleiner ist als die Größen des ersten Teils (431) und des dritten Teils (433).

10. Die Chip-Verpackungsstruktur (4000) gemäß Anspruch 9, wobei der Wicklungsabschnitt (443) um den zweiten Teil (432) des Verpackungsmitglieds (43) gewickelt ist.

## Revendications

1. Une structure d'emballage de puce (2000, 2000A, 2000B, 2000C, 2000D, 2000E, 2000G, 2000H, 4000), comprenant :
une première antenne (21, 41) ;
une puce d'identification (22, 42) connectée électriquement à la première antenne (21, 41) ;
une membre d'emballage (23, 43) encapsulant la première antenne (21, 41) et la puce d'identification (22, 42), où le membre d'emballage (23, 43) possède une surface supérieure (231), une surface inférieure (232) et une pluralité de surfaces latérales (233, 234, 235, 236) ; la surface supérieure (231) est opposée à la surface inférieure (232), et les surfaces latérales (233, 234, 235, 236) relient toutes la surface supérieure (231) et la surface inférieure (232) ; la surface supérieure (231), la surface inférieure (232) et les surfaces latérales (233, 234, 235, 236) forment substantiellement un hexaèdre ;
une deuxième antenne (24, 24A, 24B, 24C, 24D, 24E, 24F, 24G, 24H, 44), qui comprend :
une première partie d'extension (241, 241A, 241B, 241C, 241D, 241E, 241F, 241G, 241H, 441),
une deuxième partie d'extension (242, 242A, 242B, 242C, 242D, 242E, 242F, 242G, 242H, 442),
une partie d'enroulement (243, 243A, 243B, 243C, 243D, 243E, 243F, 243G, 243H, 443),
où la première partie d'extension (241, 241A, 241B, 241C, 241D, 241E, 241F, 241G, 241H, 441) est reliée à la partie d'enroulement (243, 243A, 243B, 243C, 243D, 243E, 243F, 243G, 243H, 443), la deuxième partie d'extension (242, 242A, 242B, 242C, 242D, 242E, 242F, 242G, 242H, 442) est reliée à la partie d'enroulement (243, 243A, 243B, 243C, 243D, 243E, 243F, 243G, 243H, 443), et la partie d'enroulement (243, 243A, 243B, 243C, 243D, 243E, 243F, 243G, 243H, 443) s'enroule autour des surfaces latérales (233, 234, 235, 236) du membre d'emballage (23, 43) ;
où une jonction entre chaque paire de surfaces latérales adjacentes (233, 234, 235, 236) est définie comme une partie d'angle (C1, C2, C3, C4) ; la première partie d'extension (241, 241A, 241B, 241C, 241D, 241E, 241F, 241G, 241H, 441) et la deuxième partie d'extension (242, 242A, 242B, 242C, 242D, 242E, 242F, 242G, 242H, 442) quittent respectivement le membre d'emballage (23, 43) depuis l'une des parties d'angle (C1, C2, C3, C4) ;
**caractérisée en ce que** la structure d'emballage de puce comprend en outre un adhésif (25A, 25B, 25C, 25D, 25E, 25F), conçu pour fixer la partie d'enroulement (243, 243A, 243B, 243C, 243D, 243E, 243F, 243G, 243H, 443) de la deuxième antenne (24, 24A, 24B, 24C, 24D, 24E, 24F, 24G, 24H, 44) au membre d'emballage (23, 43), où l'adhésif (25A, 25B, 25C, 25D, 25E, 25F) couvre au moins une partie de l'une des surfaces latérales (233, 234, 235, 236) et au moins une des parties d'angle (C1, C2, C3, C4).

2. La structure d'emballage de puce (1000A, 1000B, 1000C, 1000D) selon la revendication 1, dans laquelle la surface supérieure (131A, 131B, 131C, 131D) et la surface inférieure (132A, 132B, 132C, 132D) sont sensiblement parallèles l'une à l'autre, et au moins une des surfaces latérales (133A, 133B, 133C, 133D, 134, 134A, 134B, 134C, 134D, 135, 135A, 135B, 135C, 135D, 136, 136A, 136B, 136C, 136D) relie la surface supérieure (131A, 131B, 131C, 131D) et la surface inférieure (132A, 132B, 132C, 132D) de manière inclinée.

3. La structure d'emballage de puce (2000, 2000A, 2000B, 2000C, 2000D, 2000E, 2000G, 2000H, 4000) selon la revendication 1, dans laquelle la surface supérieure (231) et la surface inférieure (232) sont sensiblement parallèles l'une à l'autre, et toutes les surfaces latérales (233, 234, 235, 236) relient la surface supérieure (231) et la surface inférieure (232) de manière sensiblement orthogonale.

4. La structure d'emballage de puce (2000A) selon la revendication 1, dans laquelle la première partie d'extension (241A) et la deuxième partie d'extension (242A) quittent le membre d'emballage (23) depuis une même partie d'angle (C1, C2, C3, C4), et l'adhésif (25A) couvre au moins :
la partie d'angle (C1, C2, C3, C4) d'où la première partie d'extension (241A) et la deuxième partie d'extension (242A) quittent le membre d'emballage (23) ;
au moins une partie de l'une des surfaces latérales (233, 234, 235, 236) adjacente à ladite partie d'angle (C1, C2, C3, C4) ; et
au moins une partie de l'autre surface latérale (233, 234, 235, 236) adjacente à ladite partie d'angle (C1, C2, C3, C4).

5. La structure d'emballage de puce (2000B) selon la revendication 1, dans laquelle les parties d'angle (C1, C2, C3, C4) où la première partie d'extension (241B) quitte le membre d'emballage (23) et les parties d'angle (C1, C2, C3, C4) où la deuxième partie d'extension (242B) quitte le membre d'emballage (23) sont opposées l'une à l'autre ; une partie de la partie d'enroulement (243B) de la deuxième antenne (24B) liée à la première partie d'extension (241B) est en contact avec l'une des surfaces latérales (233, 234, 235, 236), et une autre partie de la partie d'enroulement (243B) liée à la deuxième partie d'extension (242B) est en contact avec une autre surface latérale (233, 234, 235, 236) ; l'adhésif (25B) couvre au moins :
au moins une partie de la surface latérale (233, 234, 235, 236) qui est en contact avec la partie de la partie d'enroulement (243B) liée à la première partie d'extension (241B) ;
au moins une partie de l'autre surface latérale (233, 234, 235, 236) qui est en contact avec l'autre partie de la partie d'enroulement (243B) liée à la deuxième partie d'extension (242B) ; et
les parties d'angle (C1, C2, C3, C4) définies par la jonction de ladite surface latérale (233, 234, 235, 236) et de l'autre surface latérale (233, 234, 235, 236).

6. La structure d'emballage de puce (2000C, 2000D) selon la revendication 1, dans laquelle la partie d'angle (C1, C2, C3, C4) où la première partie d'extension (241C, 241D) quitte le membre d'emballage (23) et la partie d'angle (C1, C2, C3, C4) où la deuxième partie d'extension (242C, 242D) quitte le membre d'emballage (23) sont adjacentes l'une à l'autre; une partie de la partie d'enroulement (243C, 243D) de la deuxième antenne (24C, 24D) liée à la première partie d'extension (241C, 241D) est en contact avec l'une des surfaces latérales (233, 234, 235, 236), et une autre partie de la partie d'enroulement (243C, 243D) liée à la deuxième partie d'extension (242C, 242D) est également en contact avec cette même surface latérale (233, 234, 235, 236) ; l'adhésif (25C, 25D) couvre au moins :
ladite surface latérale qui est en contact avec la partie de la partie d'enroulement (243C, 243D) liée à la première partie d'extension (241C, 241D) et avec l'autre partie de la partie d'enroulement (243C, 243D) liée à la deuxième partie d'extension (242C, 242D) ;
la partie d'angle (C1, C2, C3, C4) d'où la première partie d'extension (241C, 241D) quitte le membre d'emballage (23) ;
l'autre partie d'angle (C1, C2, C3, C4) d'où la deuxième partie d'extension (242C, 242D) quitte le membre d'emballage (23) ; et
au moins une partie de chacune des deux surfaces latérales (233, 234, 235, 236) adjacentes à ladite surface latérale (233, 234, 235, 236).

7. La structure d'emballage de puce (2000A, 2000B, 2000C, 2000D, 2000E, 2000G) selon la revendication 1, dans laquelle l'adhésif (25A, 25B, 25C, 25D, 25E, 25F, 25G) couvre l'une des surfaces latérales (233, 234, 235, 236).

8. La structure d'emballage de puce (2000G) selon la revendication 1, dans laquelle la première partie d'extension (241G) quitte le membre d'emballage (23) depuis l'une des parties d'angle (C1, C2, C3, C4), et la deuxième partie d'extension (242G) quitte le membre d'emballage (23) depuis une autre partie d'angle (C1, C2, C3, C4) ; une extrémité de la première partie d'extension (241G) éloignée de la partie d'enroulement (243G) et une extrémité de la deuxième partie d'extension (242G) éloignée de la partie d'enroulement (243G) sont reliées intégralement; lesdites parties d'angle (C1, C2, C3, C4) d'où la première partie d'extension (241G) quitte le membre d'emballage (23) et lesdites autres parties d'angle (C1, C2, C3, C4) d'où la deuxième partie d'extension (242G) quitte le membre d'emballage (23) sont adjacentes l'une à l'autre ; l'adhésif (25G) couvre :
lesdites parties d'angle (C1, C2, C3, C4) et lesdites autres parties d'angle (C1, C2, C3, C4) ;
la surface latérale (233, 234, 235, 236) qui relie lesdites parties d'angle (C1, C2, C3, C4) et lesdites autres parties d'angle (C1, C2, C3, C4) ; et
au moins une partie de chacune des deux surfaces latérales (233, 234, 235, 236) qui sont adjacentes à ladite surface latérale (233, 234, 235, 236).

9. La structure d'emballage de puce (4000) selon la revendication 1, dans laquelle le membre d'emballage (43) comprend :
une première partie (431) ;
une deuxième partie (432) ; et
une troisième partie (433) ;
dans laquelle la première partie (431) et la troisième partie (433) sont respectivement connectées à deux côtés opposés de la deuxième partie (432), et la taille de la deuxième partie (432) est inférieure aux tailles de la première partie (431) et de la troisième partie (433).

10. La structure d'emballage de puce (4000) selon la revendication 9, dans laquelle la partie d'enroulement (443) s'enroule autour de la deuxième partie (432) du membre d'emballage (43).
